# EUROPEAN PATENT SPECIFICATION

(11) **EP 4 292 982 B1**
(45) Date of publication and mention of the grant of the patent: **19.02.2025**
(21) Application number: 22211900.0
(22) Date of filing: 07.12.2022
(51) Int. Cl.: C01B 33/00, H10N 10/852, C01B 19/00, H10N 10/01

(54) **MATERIAL WITH THE GAMMA-ARGYRODITE STRUCTURE FOR THERMOELECTRIC CONVERSION AND THE METHOD OF OBTAINING THE SAME**
MATERIAL MIT GAMMA-ARGYRODIT-STRUKTUR FÜR THERMOELEKTRISCHE UMWANDLUNG UND VERFAHREN ZUR HERSTELLUNG DESSELBEN
MATÉRIAU À STRUCTURE GAMMA-ARGYRODITE POUR LA CONVERSION THERMOÉLECTRIQUE ET SON PROCÉDÉ D'OBTENTION

(30) Priority: 14.06.2022 PL 44147122
(43) Date of publication of application: 20.12.2023
(73) Proprietor: Akademia Gorniczo-Hutnicza im. Stanislawa Staszica w Krakowie, 30-059 Krakow (PL)
(72) Inventor: WOJCIECHOWSKI, Krzysztof, 32-082 Wieckowice (PL); PARASHCHUK, Taras, 31-221 Krakow (PL); CHERNIUSHOK, Oleksandr, 30-065 Krakow (PL)
(74) Representative: Rogozinska, Alicja

(56) References cited:
- ISHII M ET AL: "Structure and vibrational spectra of argyrodite family compounds Cu"8SiX"6 (X=S, Se) and Cu"8GeS"6", SOLID STATE IONICS, NORTH HOLLAND PUB. COMPANY. AMSTERDAM; NL, NL, vol. 121, no. 1-4, 2 June 1999 (1999-06-02), pages 11 - 18, XP004166450, ISSN: 0167-2738, DOI: 10.1016/S0167-2738(98)00305-1
- ISHII M ET AL: "Vibrational spectra and phase transitions of Cu"8MX"6 (M=Si, Ge; X=S, Se) and Cu"4GeS"4", SOLID STATE IONICS, NORTH HOLLAND PUB. COMPANY. AMSTERDAM; NL, NL, vol. 136-137, 2 November 2000 (2000-11-02), pages 403 - 407, XP004225959, ISSN: 0167-2738, DOI: 10.1016/S0167-2738(00)00469-0
- BRAMMERTZ G ET AL: "Fabrication and characterization of ternary Cu8SiS6and Cu8SiSe6thin film layers for optoelectronic applications", THIN SOLID FILMS, vol. 616, 24 September 2016 (2016-09-24), pages 649 - 654, XP029812157, ISSN: 0040-6090, DOI: 10.1016/J.TSF.2016.09.049
- TARAS PARASHCHUK ET AL: "Discovery of the high thermoelectric performance in low-cost Cu8SiSxSe6-x argyrodites", ARXIV.ORG, CORNELL UNIVERSITY LIBRARY, 201 OLIN LIBRARY CORNELL UNIVERSITY ITHACA, NY 14853, 4 July 2023 (2023-07-04), XP091555088

## Description

The subject of the invention is a material with the γ-argyrodite structure for thermoelectric conversion and a method of obtaining the same.

Compounds with an argyrodite structure with the general formula A^{m+}_{(12-n)/m}Bⁿ⁺Q²⁻₆ (A^{m+} = Li⁺, Cu⁺, Ag⁺; Bⁿ⁺ = Ga³⁺, Si⁴⁺, Ge⁴⁺, Sn⁴⁺, P⁵⁺, As⁵⁺; Q²⁻ = S, Se, Te) show a wide range of possibilities of use in thermoelectric applications. They are produced from widely available and environmentally friendly elements. Like other ionic conductors, argyrodites also have many polymorphic modifications. The γ-modification with high symmetry is more favorable for thermoelectric applications compared to the α-modification due to its higher thermoelectric conversion efficiency.

It is known from the publication by Chen, R.; Qiu, P.; Jiang, B.; Hu, P.; Zhang, Y; Yang, J.; Ren, D.; Shi, X.; Chen, L. Significantly Optimized Thermoelectric Properties in High-Symmetry Cubic Cu7PSe6 Compounds: Via Entropy Engineering. J. Mater. Chem. A 2018, 6 (15), 6493-6502. https://doi.org/10.1039/c8ta00631h and from the publication by Chemiushok, O.; Parashchuk, T.; Tobola, J.; Luu, S.; Pogodin, A.; Kokhan, O.; Studenyak, I.; I, B.; Piasecki, M.; Wojciechowski, K. T. Entropy-Induced Multivalley Band Structures Improve Thermoelectric Performance in p-Cu7P(SxSe1-x)6 Argyrodites. ACS Appl. Mater. Interfaces 2021, 13 (33), 39606-39620. https://doi.org/10.1021/acsami.1c11193, a way to promote the expected polymorphic modification by increasing the configurational entropy of the system by introducing a larger number of different elements into the crystal structure of the compound. When the configurational entropy is high enough, the phase transformation from α to γ can take place significantly below room temperature, which is advantageous because this material can be used over a wide range of operating temperatures maintaining high electrical transport properties.

It is known from Chinese patent application CN107235477A by Chen Hongyi; Chen Lidong; Jiang Binbin; Qiu Pengfei; Ren Dudi; Shi Xun; Zhang Qihao a method of producing argyrodite-type thermoelectric materials involving synthesis by melting stoichiometric amounts of elements in vacuum quartz containers at 1073-1473 K followed by further annealing at 723-973 K for several days. The resulting products are crushed into fine powders and sintered into polycrystalline sinters by high-temperature high-pressure sintering at 723-1000 K for 0.1-10 hours under pressure in the range of 20-200 MPa.

It is known from Korean patent application KR20190082424A by Chung In and Zhou Chongjian; argyrodite-type material for thermoelectric applications based on the chemical formula A^{m+}_{12-n/m} Bⁿ⁺X²⁻_{6-z}Y¹⁻ _{z} where A is one of Cu, Ag, Na, Li, K, Cd, Hg, and B contains one or more of Ga, Ge, Si, Sn, P and As, X contains one or more of S, Se, and Te, Y is F, Cl, Br and I, where m represents the ionic value of A, n represents the ionic value of B, and z represents a real number from 0 to 1.

It is known Chinese patent application CN106098923A by Li Wen; Lin Siqi; Pei Yanzhong; argyrodite-type material for thermoelectric applications based on the chemical formula Ag₈Sn₁₋ₓNbₓSe₆, characterized by the fact that x=0-0.05.

It is known from Chinese patent application CN108598252A by Chen Jing; Luo Jun; Wang Chenyang; Zhang Jiye argyrodite-type material for thermoelectric applications based on the chemical formula Ag₉₋ₓCu_{y}GaSe₆, characterized by y = 0, 0 ≤ x ≤ 0.1; when y ≠ 0, 0 < x = y ≤ 0.9.

It is known from Chinese patent application CN107235477A by Chen Hongyi; Chen Lidong; Jiang Binbin; Qiu Pengfei; Ren Dudi; Shi Xun; Zhang Qihao; an argyrodite-type material for thermoelectric applications based on the chemical formula Ag₉GaSe_{6-x-y}Te_{y}, characterized by 0 ≤ x ≤ 0.03, 0 ≤ y ≤ 0.75, while x and y are not 0 at the same time.

It is known from Chinese patent application CN107359231A by Li Wen; Lin Siqi; Pei Yanzhong; an argyrodite-type material for thermoelectric applications based on the chemical formula Ag₉Ga₁₋ₓMₓ(Se_{1-y}S_{y})₆, characterized by the fact, that M is the chemical element selected from Cr, Cd, Zn or Ge and 0≤x≤0.06, 0≤y≤0.10.

Publication by Ishii M. et al: "Structure and vibrational spectra of argyrodite family compounds Cu8SiX6 (X=S, Se) and Cu8GeS6, SOLID STATE IONICS, NORTH HOLLAND PUB. COMPANY. AMSTERDAM; NL, NL, vol. 121, no. 1-4, 1 June 1999 (1999-06-01), pages 11-18, XP004166450, ISSN: 0167-2738, DOI: 10.1016/S0167-2738(98)00305-1 discloses infrared transmission and Raman spectra measurements of the argyrodite family compounds Cu₈SiX₆ (X = S,Se) and Cu₈GeS₆. Structure data of Cu₈SiSe₆ and Cu₈GeS₆ at 300 K obtained through Rietveld analysis is disclosed. The document also discloses calculations of the frequencies and intensities of infrared or Raman active modes of these compounds and the relations between the vibrational spectra and the crystal structures were studied.

Publication by Ishii M. et al: "Vibrational spectra and phase transitions of Cu8MX6 (M=Si, Ge; X=S, Se) and Cu4GeS4, SOLID STATE IONICS, NORTH HOLLAND PUB. COMPANY. AMSTERDAM; NL, NL, vol. 136-137, 2 November 2000 (2000-11-02), pages 403-407, XP004225959, ISSN: 0167-2738, DOI: 10.1016/S0167-2738(00)00469-0 discloses studies of infrared transmission spectra of the high- and low-temperature phases of Cu₈MX₆ (M = Si, Ge; X = S, Se), which belong to the argyrodite family of compounds, and Cu₄GeS₄ near the phase transition temperature. These compounds undergo phase transitions in the temperature range from 320 to 360 K. The observed M-X stretching bands vary discontinuously at the transition temperature.

Publication by Brammertz G. et al: "Fabrication and characterization of ternary Cu8SiS6 and Cu8SiSeS6 thin film layers for optoelectronic applications", THIN SOLID FILMS, vol. 616, pages 649-654, XP029812157, ISSN: 0040-6090, DOI: 10.1016/J.TSF.2016.09.049 discloses fabrication and characterization of Cu₈SiS₆ and Cu₈SiSe₆ thin film layers for optoelectronic applications. The layers were fabricated using a two--step process by first evaporating a bilayer of Cu/Si on a Mo/glass substrate, followed by an anneal at temperatures in excess of 480 °C in a H₂S or H₂Se containing atmosphere. Different process conditions with different Cu starting layer thickness, different H₂S partial pressure and different anneal temperatures and times were evaluated. The best fabricated layers were thin polycrystalline layers with a relatively low amount of secondary phases. Relatively intense photoluminescence signals with a full width at half maximum of about 150 meV could be measured on the samples with a peak position of 1.84 and 1.33 eV for the Cu₈SiS₆ and Cu₈SiSe₆ materials respectively. The absorption coefficient of the Cu₈SiS₆ layer was determined from absorption and reflection measurements and was larger than 104 cm⁻¹ at energies above 1.8 eV. Fabricated material appears to be very highly doped, leading to large ohmic leakage behavior in the solar cell structures.

The purpose of the present invention is a material that is a new polymorphic modification of γ- argyrodite with a new chemical composition, and a method for obtaining it.

The essence of the material with γ- argyrodite structure for thermoelectric conversion is that it has the chemical formula Cu₈-_{δ}SiSₓSe₆₋ₓ, for 0.1 ≤ x ≤ 3 and 0 ≤ δ ≤ 0.5.

The essence of the method of obtaining γ-argyrodite-structure material for thermoelectric conversion is that a vacuum encapsulation is carried out, during which the elements Cu, Si, S, and Se of high purity above 99.99% are weighed in atomic ratio where Si : Cu : S : Se is respectively 1 : (8-δ) : x : (6-x), with the total amount of S and Se being 6 times the amount of Si, wherein δ is in range of 0 ≤ δ ≤ 0.5 and x is in range of 0 ≤ x ≤ 6,, after which the elements are mixed and sealed in a reactor. Then a melting process is carried out, during which the batch is heated to a temperature in the range of 1200 to 1600 K and kept at this temperature for at least 5 hours, to allow the synthesis to occur in a liquid state. After this is done, the batch is cooled in free mode to room temperature. Subsequently, an annealing process is carried out, during which the previously formed batch is ground into powder, which is cold pressed and annealed for 20-1000 hours at 700-1000 K under vacuum, after which it is subjected to free cooling to room temperature to obtain a homogeneous material. Finally, a pressure-assisted sintering process is carried out, during which the annealed material is ground into a fine powder, which is placed in a graphite mold and heated to a temperature of 900 - 1100 K, and densified at a pressure of 20-200 MPa, for a time of 10-600 minutes, after which the material is subjected to slow cooling at a cooling rate of 1-30 K/min.

Advantageously, the heating of the annealed material ground into a fine powder during the pressure-assisted sintering process is carried out by the spark plasma sintering (SPS) method.

The developed thermoelectric materials are produced from environmentally harmless and relatively inexpensive chemical elements, enabling the manufacture of thermoelectric converters for common applications (e.g., waste heat recovery, solar and geothermal energy conversion).

By optimizing the composition and synthesis conditions, a modification of γ-argyrodite Cu₈SiSₓSe₆₋ₓ, with good thermoelectric properties is obtained. The concentration of charge carriers is optimized by introducing an appropriate deficiency of Cu, which makes it possible to achieve a high energy conversion efficiency of 13%. In comparison, the efficiency of commercially available thermoelectric modules based on Bi₂Te₃ alloys is only 5-6%. In addition, the high-performance Cu₈₋₆SiSₓSe₆₋ₓ material contains only low-cost and environmentally friendly elements, significantly reducing thermoelectric device prices.

Adding sulfur in place of selenium in Cu₈SiSₓSe₆₋ₓ (x = 0.1-3) stabilizes the favorable high-temperature γ-polymorphic modification and improves the thermoelectric power factor of this material over the entire temperature range. Optimization of the carrier concentration by Cu deficiency defects further improves the thermoelectric efficiency of η. The Cu_{8-δ}SiSₓSe₆₋ₓ has a high efficiency η = 13% at 773 K with a temperature difference from 298 K to 773 K.

### Embodiment

The object of the invention is presented in the drawing in which Fig. 1 (a) shows the entropy change in the system due to the substitution of selenium by sulfur and (b) the γ - argyrodite crystal structure of Cu₈SiS₃Se₃; Fig. 2 shows an electron microscope image of the selected sample after sintering; the graph in Fig. 3 shows the dependence of the material energy conversion efficiency on the temperature difference ΔT.

The argyrodite thermoelectric copper-silicon-sulfur-selenium material with the chemical formula Cu_{7.95}SiS₃Se₃ is obtained by the following procedure:
(1) Powders of copper of 5.3312 g, silicon of 0.3242 g, sulfur of 1.1104 g, and selenium of 2.7342 g with a purity of 99.99% are mixed and then sealed under a vacuum of 10⁻⁵ mbar in a quartz ampoule coated inside with graphite;
(2) The quartz ampoule containing the raw material is placed in a high-temperature muffle furnace, which is slowly heated to 1400 K for 10 hours, and maintained at this temperature for 5 hours, which allows the components to react in a liquid state, followed by free cooling to room temperature to obtain the first ingot;
(3) The resulting ingot is ground to powder, cold-pressed, and annealed for 170 hours at 873 K in quartz ampoules under vacuum to obtain a homogeneous material. The material is then cooled freely to room temperature;
(4) The annealed material is ground into a fine powder, placed in a graphite mold, and heated at a rate of 70 K/min to 1023 K. It is then densified by spark plasma sintering (SPS) method at 60 MPa, for 60 minutes. The resulting sinter is subjected to slow cooling at a rate of 15 K/min.

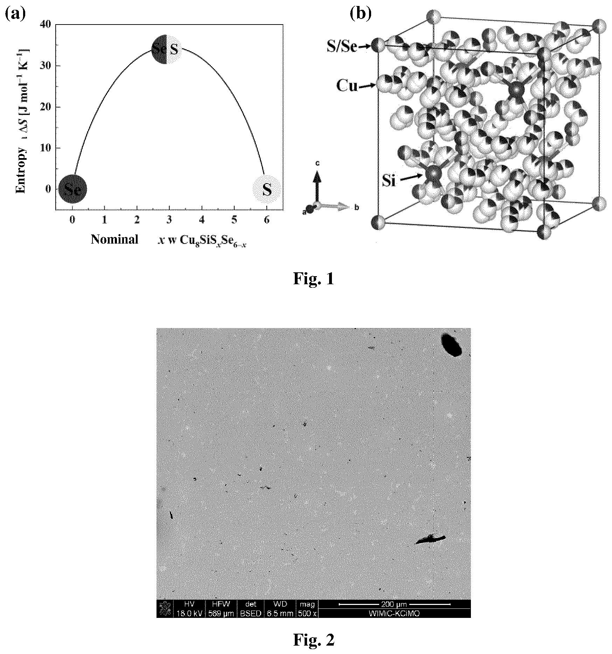

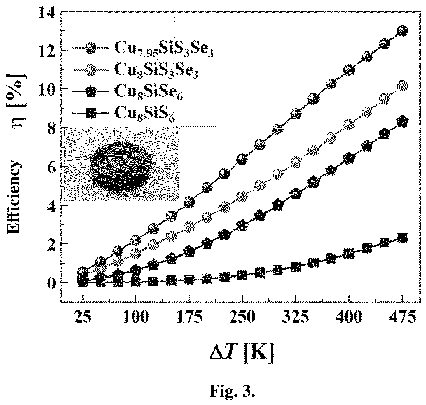

Fig. 1a shows the changes in the configurational entropy of the Cu₈SiSₓSe₆₋ₓ system depending on the amount of sulfur and selenium. Calculations show that the compound with composition Cu₈SiS₃Se₃ has the highest configurational entropy and (the largest disorder in the Se/S sublattice) which is shown schematically in the crystal structure drawing (Fig. 1b). Such a chemical composition causes the obtained compound to have the structure of the polymorphic modification of γ-argyrodite already at room temperature, which was confirmed by X-ray diffraction XRD and differential scanning calorimetry DSC methods. Fig. 2. shows an example of a scanning electron microscope SEM image obtained after sintering of the material. The values of energy conversion efficiencies for Cu₈SiSₓSe₆₋ₓ samples determined from measurements of electrical and thermal properties are shown in Fig. 3. The obtained materials with the composition of Cu₈SiSₓSe₆₋ₓ have significantly higher thermoelectric power factor and ultra-low thermal conductivity compared to undoped Cu₈SiS₆ and Cu₈SiSe₆. A maximum efficiency of 10.2% is achieved for a composition with x = 3 at 773 K. Nevertheless, the material has too_small number of p-type carriers.

Further optimization of the concentration of p-type charge carriers allows for an additional increase in efficiency. The optimal concentration of carriers (holes) was achieved by intentionally created deficiency of copper in the Cu_{8-δ}SiS₃Se₃. As a result, the efficiency (Fig. 3) for the Cu_{8-δ}SiS₃Se₃ samples reached a value of ~13% at 773 K for a sample with δ = 0.05. This value of efficiency is the highest value reported to date for materials with a p-type argyrodite structure. In summary, the estimated efficiency (Fig. 3) for the components made of the obtained materials at a temperature difference of 475 K shows that α-Cu₈SiS₆ has an efficiency of 2.3%, α-Cu₈SiSe₆ - 8.3%, while the γ-Cu₈SiS₃Se₃ modification shows an efficiency of 10.2%. On the other hand, with the optimal composition of Cu_{7.95}SiS₃Se₃, the efficiency increases to 13.0 %.

## Claims

1. A material with the γ-argyrodite structure for thermoelectric conversion is **characterized by** the chemical formula of Cu_{8-δ}SiSₓSe₆₋ₓ for 0.1 ≤ x ≤ 3 and 0 ≤ δ ≤ 0.5

2. A method of obtaining a material with γ-argyrodite structure for thermoelectric conversion, **characterized in that** vacuum encapsulation is carried out, during which the elements Cu, Si, S and Se are weighed in atomic ratio where Si : Cu : S : Se is respectively 1 : (8-δ) : x : (6-x), with the total amount of S and Se being 6 times the amount of Si, wherein δ is in range of 0 ≤ δ ≤ 0.5 and x is in range of 0 ≤ x ≤ 6, after which these elements are mixed and sealed in a reactor, then a melting process is carried out, during which the batch is heated to a temperature in the range of 1200 to 1600 K and kept at this temperature to allow liquid synthesis to take place, after which the batch is cooled in free mode to room temperature, then a processing is carried out, during which the previously formed batch is ground into powder, which is pressed and annealed for 20-1000 hours at a temperature of 700-1000 K under vacuum, and finally a pressure-assisted sintering process is carried out, during which the annealed material is ground into fine powder, which is placed in a mold and heated to a temperature of 900 - 1100 K, and densified at a pressure of 20-200 MPa, for a period of 10-600 minutes, after which the material is subjected to slow cooling at a cooling rate of 1-30 K/min.

3. The method of obtaining a material with the γ-argyrodite structure for thermoelectric conversion, according to claim 2 **characterized in that** the heating of the annealed material ground into a fine powder during the pressure-assisted sintering process is carried out by the spark plasma sintering (SPS) method.

## Patentansprüche

1. Material mit einer γ-Argyroditstruktur zur thermoelektrischen Umwandlung, **gekennzeichnet durch** eine chemische Formel Cu_{8-δ}SiSₓSe₆₋ₓ, wobei 0.1 ≤ x ≤ 3 and 0 ≤ δ ≤ 0.5.

2. Verfahren zur Herstellung eines Materials mit einer γ-Argyroditstruktur zur thermoelektrischen Umwandlung, **dadurch gekennzeichnet, dass** eine Vakuumeinkapselung durchgeführt wird, bei der die Elemente Cu, Si, S und Se in Atomverhältnis Si : Cu : S : Se von 1 : (8-δ) : x : (6-x) eingewogen werden, wobei die Gesamtmenge an S und Se das 6-fache der Menge an Si beträgt, wobei δ im Bereich von 0 ≤ δ ≤ 0.5 und x im Bereich von 0 ≤ x ≤ 6 liegen, wonach diese Elemente in einem Reaktor gemischt und versiegelt werden, dann ein Schmelzprozess durchgeführt wird, bei dem der Einsatz auf eine Temperatur im Bereich von 1200 bis 1600 K erwärmt und auf dieser Temperatur gehalten wird, um eine Synthese im flüssigen Zustand stattfinden zu lassen, wonach der Einsatz frei auf Raumtemperatur abgekühlt wird, dann eine Bearbeitung durchgeführt wird, bei der der zuvor gebildete Einsatz zu Pulver vermahlen wird, das unter Vakuum durch 20 - 1000 Stunden bei einer Temperatur von 700 - 1000 K gepresst und ausgeheizt wird, und schließlich ein Drucksinterverfahren durchgeführt wird, bei dem das ausgeheizte Material zu Feinpulver vermahlen wird, das in eine Form eingebracht und auf eine Temperatur von 900-1100 K erwärmt sowie bei einem Druck von 20-200 MPa für einen Zeitraum von 10-600 Minuten verdichtet wird, wonach das Material langsam bei einer Abkühlgeschwindigkeit von 1-30 K/min abgekühlt wird.

3. Verfahren zur Herstellung eines Materials mit einer γ-Argyroditstruktur zur thermoelektrischen Umwandlung nach Anspruch 2, **dadurch gekennzeichnet, dass** das Erhitzen des zu Feinpulver vermahlenen ausgeheizten Materials während des Drucksinterverfahrens mit dem stromunterstützten Sinterverfahren (SPS-Verfahren) erfolgt.

## Revendications

1. Matériau ayant une structure de γ-argyrodite pour la conversion thermoélectrique, **caractérisé en ce que** sa formule chimique est Cu_{8-δ}SiS*ₓ*Se_{6-*x*} où 0.1 ≤ x ≤ 3 et 0 ≤ δ ≤ 0.5.

2. Procédé pour obtenir un matériau ayant une structure de γ-argyrodite pour la conversion thermoélectrique, **caractérisé en ce que** on réalise une encapsulation sous vide, durant laquelle les éléments Cu, Si, S et Se on pèse dans des proportions atomiques Si:Cu:S:Se égales 1: (8-δ) : x : (6-x), la quantité totale de S et Se étant 6-fois celle de Si, δ se situant entre 0 ≤ δ ≤ 0.5, et x se situant entre 0.1 ≤ x ≤ 3, suite à quoi on mélange les éléments et on referme hermétiquement dans un réacteur, ensuite on réalise le processus de fusion, durant lequel la charge est chauffée jusqu' à une température dans la plage de 1200 à 1600 K et on les maintient dans cette température de sorte à rendre possible la synthèse en état liquide, par la suite on refroidit la charge en mode libre jusqu'à la température ambiante, successivement on réalise le processus de traitement, durant lequel la charge obtenue ultérieurement est réduite en poudre, qui est pressée et maintenue durant 20-1000 heures à une température de 700 à 1000 K dans un vide, et à la fin on mène le processus de frittage sous pression, durant lequel le matériau recuit est réduit en poudre fine, laquelle est placée dans un moule et chauffée à une température de 900 à 1100 K, et on la concentre sous pression de 20-200 MPa, durant 10-600 minutes, après quoi le matériau est soumis à un refroidissement lent avec une vitesse de refroidissement de 1-30 K/min.

3. Procédé de production d'un matériau ayant une structure de γ-argyrodite pour la conversion thermoélectrique selon la revendication 2, **caractérisé en ce que** le chauffage du matériau recuit réduit en poudre fine, durant le processus de frittage sous pression est réalisé par la méthode de frittage soutenu par un flux de courant électrique (SPS).
